(19) **Europäisches Patentamt / European Patent Office / Office européen des brevets**

(11) **EP 3 659 804 B1**

(12) **FASCICULE DE BREVET EUROPEEN**

(45) Date de publication et mention de la délivrance du brevet:
**19.04.2023 Bulletin 2023/16**

(21) Numéro de dépôt: **19211933.7**

(22) Date de dépôt: **27.11.2019**

(51) Classification Internationale des Brevets (IPC):
***H01Q 1/38** (2006.01)*      ***H05K 1/16** (2006.01)*
***H05K 3/12** (2006.01)*

(52) Classification Coopérative des Brevets (CPC):
B32B 33/00; **H01Q 1/38; H05K 1/165;**
**H05K 3/1225; H05K 3/1233;** B29C 53/04;
B29C 53/562; B29K 2995/0006; B29K 2995/0008;
B29L 2031/3456; B32B 2310/12; B32B 2457/00;
H05K 1/0393; H05K 2201/0145; H05K 2201/0154;

(Cont.)

(54) **FEUILLE PRÉSENTANT DES PROPRIÉTÉS DIÉLECTRIQUES OU MAGNÉTO-DIÉLECTRIQUES**

FOLIE MIT DIELEKTRISCHEN ODER MAGNETO-DIELEKTRISCHEN EIGENSCHAFTEN

SHEET HAVING DIELECTRIC OR MAGNETO-DIELECTRIC PROPERTIES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **28.11.2018 FR 1871977**

(43) Date de publication de la demande:
**03.06.2020 Bulletin 2020/23**

(73) Titulaire: **Commissariat à l'Energie Atomique et aux Energies Alternatives**
**75015 Paris (FR)**

(72) Inventeurs:
• **PINTOS, Jean-François**
**38054 Grenoble Cedex 09 (FR)**
• **BENWADIH, Mohammed**
**38054 Grenoble Cedex 09 (FR)**

(74) Mandataire: **Cabinet Nony**
**11 rue Saint-Georges**
**75009 Paris (FR)**

(56) Documents cités:
**WO-A1-2013/154713    US-A1- 2011 135 884**

• **GHAFFAR FARHAN A ET AL: "A ferrite nano-particles based fully printed process for tunable microwave components", 2016 IEEE MTT-S INTERNATIONAL MICROWAVE SYMPOSIUM (IMS), IEEE, 22 May 2016 (2016-05-22), pages 1-3, XP032941195, DOI: 10.1109/MWSYM.2016.7540171 [retrieved on 2016-08-10]**

EP 3 659 804 B1

(52) Classification Coopérative des Brevets (CPC):
(Cont.)
H05K 2201/0158; H05K 2201/055;
H05K 2201/10098; H05K 2203/0139;
H05K 2203/107

## Description

### Domaine technique

La présente invention concerne une structure composite comportant une feuille aux propriétés magnéto-diélectriques anisotropes, ainsi qu un procédé de fabrication associé.

### Technique antérieure

Une antenne électromagnétique chargée est généralement constituée d'une pièce métallique conductrice et d'un matériau magnéto-diélectrique, généralement une ferrite, présentant à la fois une permittivité relative et une perméabilité relative supérieures à 1,0. Un organe électriquement conducteur, généralement un fil, est enroulé autour de la pièce de manière à former une bobine, concentrant au sein de la pièce des lignes d'un champ magnétique.

La fabrication en grande série de telles pièces s'avère à la fois complexe et coûteuse, puisqu'elle nécessite une mise en forme, généralement par pressage, d'une poudre de particules faites du matériau magnéto-électrique, suivie d'un frittage, pour obtenir chaque pièce. En outre, la mise en forme et le frittage des poudres résulte en une pièce présentant une structure sensiblement homogène et des propriétés magnéto-diélectriques sensiblement isotropes.

Il est connu de l'article « Engineered meta substrate for antenna miniutarization », H. Mosallaei et K. Sarabandi, Ann. Arbor, vol. 1001, pp. 48109-2122, 2004, de définir une antenne au moyen d'une structure composite magnéto-diélectrique. Ce type d'antenne est toutefois complexe à fabriquer, car il nécessite d'empiler de façon alterné et de lier entre elles de nombreuses couches en matériau diélectrique et en ferrite hexagonale. Une antenne formée d'un motif en méandre gravé sur un support diélectrique ou magnéto-diélectrique est aussi connue de WO 2011/036418 A1. US 2011/135884 A1 et WO 2013/154713 A1 sont aussi utiles à la compréhension de l'invention.

L'article « A ferrite nano-particles based fully printed process for tunable microwave components », Farhan A. Ghaffar et al., 2016, IEEE MTT-S International Microwave Symposium, décrit un procédé d'impression d'une encre magnétique à base de $Fe_2O_3$.

Il existe donc un besoin pour un nouveau matériau pouvant être fabriqué en quantités industrielles, aisément et à moindre coût, et dont les propriétés magnéto-diélectriques sont anisotropes, un tel matériau pouvant notamment être destiné à la production d'une antenne électromagnétique.

### Résumé de l'invention

L'invention a ainsi pour objet une structure composite telle que définie à la revendication 1.

La feuille définit ainsi un matériau composite présentant des propriétés diélectriques ou magnéto-diélectriques anisotropes, qui dépendent de la permittivité relative du support diélectrique, de la permittivité relative et le cas échéant, de la perméabilité relative, du revêtement, ainsi que de la disposition du revêtement par rapport au support et des proportions en volume du revêtement et du support.

Comme cela apparaîtra plus clairement par la suite, la feuille contenue dans la structure composite selon l'invention peut être fabriquée simplement, par exemple par impression, notamment par sérigraphie, du revêtement sur le support à plat.

Une propriété, par exemple la permittivité relative ou la perméabilité relative, est anisotrope lorsqu'elle varie en fonction de la direction de l'espace selon laquelle elle est mesurée.

Le support est « flexible », c'est-à-dire qu'il fléchit sous l'effet de son propre poids.

Le support est de préférence mince, c'est-à-dire qu'il présente une épaisseur au moins 10 fois inférieure, voire au moins 100 fois inférieure à sa largeur et/ou à sa longueur.

En particulier, l'épaisseur du support peut être comprise entre 1 $\mu$m et 10 mm.

Le support peut être monolithique. En variante, il peut être multicouche et être formé d'une pluralité de matériaux présentant des propriétés diélectriques différentes.

Le support peut comporter des évidements le traversant de part en part dans son épaisseur, par exemple chacun de forme cylindrique de révolution. La présence d'évidements modifie localement la permittivité relative du support et diminue la masse de la feuille.

Par ailleurs, le support est en un matériau de support présentant des propriétés diélectriques, c'est-à-dire qu'il présente une perméabilité relative égale à 1,0. Il peut présenter une permittivité relative supérieure à 1,0, notamment supérieure à 2,0, voire supérieure à 3,0.

Le matériau de support est de préférence choisi parmi un polymère, notamment thermoplastique ou thermodurcissable, et un composite à base de fibres de verre et leurs mélanges. Le polymère peut être choisi parmi un polyimide, le PVS (polyvinyl siloxane), le PE (polyéthylène), le PP (polypropylène), le PS (polystyrène), l'ABS (acrylonitrile butadiène styrène), le PC (polycarbonate) et leurs mélanges. Par exemple, le polymère est le Kapton® commercialisé par la société Dupont, et le composite à base de fibres de verre est le FR4.

Le support peut présenter des propriétés adhésives. En particulier, le support peut comporter un adhésif.

Le revêtement est de préférence en contact, de préférence intégralement, d'au moins une face du support.

Le revêtement peut présenter une épaisseur comprise entre 1 $\mu$m et 2 mm, notamment dans une variante où le support présente une épaisseur comprise entre 75 $\mu$m et 250 $\mu$m, par exemple d'environ 125 $\mu$m.

Le matériau de revêtement est différent du matériau de support. Il présente des propriétés magnéto-diélectriques.

Le matériau de support peut présenter une permittivité relative supérieure à 1,0, notamment supérieure à 2,0, voire supérieure à 3,0.

Selon une variante non couverte par l'invention telle que revendiquée, le matériau de revêtement peut présenter des propriétés diélectriques, c'est-à-dire qu'il présente une perméabilité relative égale à 1,0. Le matériau de revêtement peut être choisi parmi le polyvinylidènedifluoride-trifluoroéthylène (PVDF-TrFE), le polystyrène (PS), le poly-4-vinylphenol (PVP), le polyméthacrylate (PMMA), le polyimide (PI) et leurs mélanges.

Selon l'invention telle que revendiquée, le matériau de revêtement est magnéto-diélectrique. De préférence, la perméabilité relative du matériau de revêtement est supérieure à 1,0, de préférence supérieure à 5,0, de préférence supérieure à 10,0, mieux supérieure à 50,0. De préférence, selon la deuxième variante, le matériau de revêtement comporte, voire consiste en, une ferrite.

Le matériau de revêtement peut comporter, voire être constitué par une matrice et de particules, en un matériau magnétique et/ou en un matériau magnéto-diélectrique, dispersées dans la matrice.

La matrice peut être une résine organique isolante. Elle peut être une résine polystyrène, une résine siliconée, une résine acrylate, une résine polyuréthane ou leurs mélanges.

Les particules peuvent être magnétiques. Notamment, elles peuvent être en un métal choisi parmi le cobalt, le fer, le nickel et leurs alliages, notamment un alliage de cobalt et de fer ou un alliage de fer et de nickel.

Les particules peuvent être en un oxyde de fer de formule $Fe_2O_3XO$, avec X choisi parmi le manganèse, le zinc, le cobalt, le nickel et leurs mélanges.

Les particules peuvent être en un alliage de cuivre, de manganèse et de zinc.

Elles peuvent être en un alliage de manganèse et de zinc, notamment lorsque la feuille est destinée à former une antenne opérant à une fréquence comprise entre 10 kHz et 1 MHz.

Elles peuvent être en un alliage de nickel et de zinc, ou de zinc, de nickel et de cuivre, notamment lorsque la feuille est destinée à former une antenne opérant à une fréquence comprise entre 1 et 500 MHz.

De préférence, le revêtement est obtenu par dépôt sur le support, de préférence par sérigraphie, d'une encre comportant ledit matériau de revêtement.

Le revêtement recouvre, au moins partiellement, au moins une face du support. Il peut recouvrir intégralement au moins une face du support. Il peut recouvrir moins de 90 %, voire moins de 80 %, voire moins de 60 %, voire moins de 40 %, moins de 20 % de l'aire d'une face du support.

Le revêtement peut recouvrir deux faces opposées du support.

Le revêtement peut être continu sur la ou les faces du support qu'il recouvre.

Le revêtement peut recouvrir le support sur une portion, définie s'étendant entre deux bords latéraux opposés du support, qui présente une aire qui croît ou décroît, par exemple de manière monotone et de préférence linéairement, lorsqu'on parcourt le support selon une direction parallèle aux bords latéraux. Par exemple, vue selon une direction normale à la face du support couvert par la portion, la portion peut présenter une forme de triangle, dont les sommets sont par exemple disposés sur les bords latéraux de la feuille.

Dans une variante, le revêtement est discontinu sur la ou les faces du support qu'il recouvre. En particulier, le revêtement peut être formé de motifs élémentaires espacés les uns des autres. Au moins un et de préférence tous les motifs élémentaires présentent une forme polyédrique, par exemple choisie parmi un rectangle, un hexagone, un losange est un carré, ou une forme de disque ou d'ellipse, ou une forme de bande ondulée.

Les motifs élémentaires peuvent présenter chacun une forme rectangulaire, par exemple carrée.

Le revêtement peut comporter une pluralité de premiers motifs élémentaires et une pluralité de deuxièmes motifs élémentaires, les premiers motifs élémentaires et deuxièmes motifs élémentaires présentant des formes différentes.

Les motifs élémentaires définissent de préférence un agencement régulier, de préférence périodique, selon au moins une, de préférence deux directions, notamment selon la largeur et/ou la longueur de la feuille. Par exemple, les motifs élémentaires définissent un damier.

Les motifs élémentaires peuvent être disposés en quinconce les uns par rapport aux autres.

Par ailleurs, la feuille peut comporter un adhésif. L'adhésif peut présenter des propriétés diélectriques.

En particulier, la feuille peut comporter une couche comportant l'adhésif, dénommée par la suite couche d'adhésif, qui recouvre au moins partiellement le support. Ainsi, lorsqu'on enroule la feuille autour d'un axe d'enroulement, on facilite le maintien entre elles des spires consécutives de la feuille ainsi enroulée.

La couche d'adhésif peut être au contact d'une face du support opposée à celle de laquelle le revêtement est en contact. En variante, le revêtement peut être pris en sandwich entre la couche d'adhésif et le support.

De préférence, la feuille comporte une couche métallique. La couche métallique peut recouvrir au moins partiellement et de préférence partiellement seulement, une face du support. Dans une variante, la feuille constitue au moins partiellement une antenne électromagnétique. Les courants induits dans la couche métallique transforment ainsi une onde guidée en onde propagée.

La couche métallique et le revêtement peuvent recouvrir une même face du support ou des faces opposées.

De préférence, la couche métallique et le revêtement peuvent recouvrir l'intégralité de la face du support sur laquelle ils sont disposés.

La couche métallique et le revêtement peuvent être disposés à distance l'un de l'autre.

En variante, le revêtement peut être recouvert par la couche métallique, qui de préférence est continue. Selon au moins une direction radiale, le revêtement peut être au contact des faces en regard de deux enroulements consécutifs du support et selon au moins une autre direction radiale, une des faces du revêtement peut être au contact d'une desdites faces des deux enroulements consécutifs et son autre face peut être au contact de la couche métallique.

La feuille peut présenter des formes variées. De préférence, elle est mince, c'est-à-dire que son épaisseur est inférieure à au moins 10 fois, voire à au moins 100 fois sa largeur et/ou sa longueur.

En particulier, la feuille peut présenter une forme d'une bande. La bande peut être de forme parallélépipédique, et peut présenter des bords longs droits ou ondulés ou crénelés. La largeur de la feuille peut être comprise entre 1 mm et 1 m. La longueur de la feuille peut être comprise entre 10 mm et 1 m.

Comme cela a été décrit plus haut, la feuille définit un matériau composite. De part sa flexibilité, la feuille peut être déformée pour former différentes structures composites présentant des propriétés diélectriques ou magnéto-diélectriques anisotropes spécifiques.

L'invention concerne ainsi une structure composite comportant une feuille selon l'invention enroulée sur elle-même autour d'un axe d'enroulement, ou repliée sur elle-même.

De préférence, la structure composite comporte une feuille enroulée, de préférence entièrement, sur elle-même.

De préférence, dans la feuille enroulée, le revêtement est pris en sandwich entre les deux faces en regard de deux enroulements consécutifs du support.

Dans la feuille enroulée, le revêtement peut être en contact, de préférence intégralement, sur chacune de ses faces, avec les faces opposées du support.

En particulier, le revêtement peut être au contact des deux faces en regard de deux enroulements consécutifs de la feuille enroulée.

De préférence, la feuille enroulée définit une spirale d'axe parallèle à l'axe d'enroulement. De préférence, l'axe de la spirale est confondu avec l'axe d'enroulement.

De préférence, l'axe d'enroulement est parallèle à un bord de la feuille et est perpendiculaire à un autre bord de la feuille.

De préférence, dans la feuille enroulée, le support et le revêtement présentent des formes de spirales complémentaires l'une de l'autre.

De préférence, la feuille enroulée présente une forme générale tubulaire, et de préférence creuse, s'étendant selon l'axe d'enroulement.

De préférence, la feuille selon l'invention est enroulée le long d'un trajet d'enroulement définissant de préférence une spirale perpendiculaire à l'axe d'enroulement.

Les dimensions de la feuille peuvent être choisies en fonction de l'application à laquelle elle est destinée. Par exemple, dans une application où la feuille est enroulée pour définir au moins partiellement une antenne électromagnétique, les dimensions sont régies par des lois physiques et dépendent pour partie de la longueur d'onde de fonctionnement de l'antenne.

Le diamètre extérieur de la feuille enroulée, mesuré dans un plan transversal à l'axe d'enroulement, et correspondant à la plus grande dimension de la feuille dans le dit plan, peut être compris entre 1 mm et 10 cm. Le diamètre intérieur de la feuille enroulée, mesuré dans un plan transversal à l'axe d'enroulement, peut être compris entre 1 mm et 10 cm. La largeur de la feuille enroulée, mesurée selon l'axe d'enroulement, peut être comprise entre 1 mm et 1 m.

Par ailleurs, la feuille enroulée peut comporter un fil métallique ou un ruban métallique enroulé autour de l'axe d'enroulement, et formant par exemple une hélice. Le fil ou le ruban est de préférence au contact du support et/ou du revêtement. Dans une variante, la feuille enroulée constitue au moins partiellement une antenne électromagnétique. Les courants induits dans le fil métallique ou le ruban métallique y transforment ainsi une onde guidée en onde propagée.

Par ailleurs, la structure composite peut comporter un adhésif disposé entre deux enroulements successifs de la feuille enroulée.

L'adhésif peut se présenter sous la forme d'une couche recouvrant au moins partiellement, voire complètement une face du support. De préférence, l'adhésif est au contact d'une face du support et le revêtement est au contact de la face opposée du support.

L'adhésif peut présenter des propriétés diélectriques.

L'adhésif peut être enduit sur la feuille avant l'enroulement de la feuille.

L' adhésif peut être au contact par une de ses faces avec le support et par une face opposée au revêtement. L'adhésif augmente la cohésion des enroulements consécutifs de la feuille enroulée au sein de la structure composite.

L'adhésif peut être au contact de deux faces opposées du support. En particulier, il peut être au contact des faces en regard de deux enroulements consécutifs du support.

Dans une variante où le support est recouvert sur chacune de ses deux faces opposées par un revêtement, l'adhésif peut être pris en sandwich entre, voire être en contact avec, les revêtements disposés sur les faces opposées de deux enroulements consécutifs du support.

Par ailleurs, la structure composite peut comporter un manchon s'étendant le long de l'axe d'enroulement et ceinturant la feuille enroulée. Ainsi, on évite un déroulement de la feuille enroulée. La structure composite peut comporter le manchon et l'adhésif.

De préférence, le manchon présente une forme complémentaire à celle de la feuille enroulée. En particulier, le manchon peut être au contact au moins partiellement et de préférence totalement avec la face radialement extérieure de la feuille enroulée.

Une direction « radiale » est perpendiculaire à l'axe d'enroulement et intersecte l'axe d'enroulement. Un organe ou une surface radialement intérieure est plus proche de l'axe d'enroulement, selon une direction radiale, qu'un organe ou une surface radialement extérieure.

La présente divulgation concerne aussi une structure composite comportant au moins deux feuilles contenues dans la structure composite selon l'invention empilées les unes sur les autres selon une direction d'empilement, les feuilles s'étendant chacune dans un plan normal à la direction d'empilement, au moins une feuille, et de préférence toutes les feuilles, étant telle que le revêtement recouvre moins de 90 % d'une face du support.

La structure composite peut comporter plus de 10, voire plus de 100 feuilles empilées les unes sur les autres.

La présente divulgation concerne encore une antenne électromagnétique comportant une structure composite selon l'invention.

De préférence, l'antenne est configurée pour émettre et/ou recevoir un signal radiofréquence, de préférence présentant une longueur d'onde fondamentale inférieure à 10 GHz, de préférence comprise entre 1 MHz et 1 GHz.

La présente divulgation concerne encore un dispositif pour émettre et/ou capter une onde électromagnétique, le dispositif comportant une antenne électromagnétique selon la présente divulgation.

De préférence, le dispositif est choisi parmi un téléphone portable, un ordinateur portable, un véhicule terrestre, un aéronef, un bateau, un satellite.

L'invention concerne également un procédé de fabrication tel que défini à la revendication 11.

On peut former le revêtement sur une unique face du support. Dans une variante, on peut former le revêtement sur chacune des faces opposées du support.

De préférence, le matériau de revêtement se présente sous la forme de particules, de préférence présentant une taille moyenne comprise entre 50 nm et 10 $\mu$m. La « taille » d'une particule correspond au diamètre de la plus petite sphère qui est circonscrite à la particule. Par « taille moyenne » des particules, on entend une moyenne arithmétique des tailles de particules. La taille moyenne des particules peut être choisie en fonction de l'épaisseur du revêtement désirée. Par exemple, la taille moyenne des particules peut être supérieure à 1 $\mu$m dans une variante où l'épaisseur du revêtement est comprise entre 10 $\mu$m et 30 $\mu$m. Les particules peuvent présenter une taille moyenne inférieure à 1 $\mu$m, par exemple dans une variante où le revêtement comporte une matrice organique dans laquelle les particules sont dispersées.

La teneur massique en matériau de revêtement, exprimée sur la base de la masse de l'encre, peut être comprise entre 30 % et 60 %, de préférence comprise entre 40 % et 50 %.

De préférence, l'encre comporte un solvant dans lequel des particules faites du matériau de revêtement sont dispersées.

De préférence, la viscosité Brookfield de l'encre est comprise entre 100 mPa.s et 50000 mPa.s, de préférence est inférieure ou égale à 700 mPa.s. La viscosité Brookfield peut être mesurée au moyen d'un viscosimètre Brookfield KU-II commercialisé par la société Brookfield, après une phase d'homogénéisation de l'encre opérée à une vitesse de rotation de 2750 tours par minutes pendant 5 minutes à 25°C. La viscosité Brookfield de l'encre peut être choisie en fonction de l'épaisseur du revêtement souhaitée. Par exemple, pour un dépôt par sérigraphie, elle est de préférence comprise entre 5000 mPa.s et 25000 mPa.s, et notamment inférieure ou égale à 10000 mPa.s.

L'encre peut présenter un champ coercitif compris entre 2000 et 4000, par exemple d'environ 3500.

L'encre peut présenter une densité comprise entre 1 kg/l et 4 kg/l, par exemple d'environ 1,3 kg/l.

L'encre peut présenter une résistance carrée d'environ $10^8$ $\Omega$.

De préférence, on dépose l'encre au moyen d'une technique choisie parmi la sérigraphie, le dépôt à la tournette, le dépôt au racloir, le dépôt par spray ultrasonique, l'enduction par filière à fente, l'impression jet d'encre, l'héliogravure, et la flexographie.

De manière plus particulièrement préférée, on dépose l'encre par sérigraphie. La sérigraphie facilite l'impression sur un support de grande surface. Elle est particulièrement bien adaptée à l'impression sur un large panel de matériaux diélectriques, notamment sur les matériaux plastiques tels que les polyimides, le PVS (polyvinyl siloxane), le PE (polyéthylène), le PP (polypropylène), le PS (polystyrène) ou l'ABS (acrylonitrile butadiène styrène).

De préférence, on forme une couche métallique telle que décrite ci-dessus sur une, et de préférence unique, face du support. On peut former la couche métallique et le revêtement sur une même face du support.

On peut former la couche métallique et le revêtement conjointement. En variante, on forme d'abord le revêtement et ensuite la couche métallique. On peut déposer la couche métallique au moins en partie, voire totalement, sur le revêtement.

On peut former la couche métallique par dépôt d'une encre comportant un métal. La couche métallique peut être déposée sur le support et/ou le revêtement par une des techniques décrites ci-dessus, de préférence par sérigraphie.

Le procédé peut comporter une étape d'encollage consistant à déposer un adhésif, de préférence sous la forme d'une couche, sur le support avant ou après le dépôt du revêtement.

Le procédé peut comporter une étape de poinçonnage du support, pour modifier la densité de matériau de support diélectrique localement. Le support peut être poinçonné avant ou après que l'encre ait été déposée sur le support.

Selon une première variante selon l'invention, la méthode de mise en forme comporte l'enroulement de la feuille sur elle-même autour d'un axe d'enroulement.

De préférence, la feuille est enroulée autour d'un mandrin. Le mandrin présente par exemple une forme cylindrique de révolution, et s'étend le long de l'axe d'enroulement. Une telle forme facilite l'obtention d'une feuille enroulée de forme générale cylindrique de révolution.

La méthode de mise en forme peut comporter une étape de sertissage selon laquelle on vient disposer autour de la feuille enroulée un manchon ceinturant radialement ladite feuille enroulée.

Selon une deuxième variante selon l'invention, la méthode de mise en forme peut comporter le pliage de la feuille sur elle-même, notamment de façon à mettre en contact une face de la feuille avec elle-même. En particulier, le pliage peut être effectué le long d'une ligne de pli parallèle à un bord de la feuille. La feuille peut comporter une couche d'adhésif, portée par une face du support, et la feuille est pliée de sorte à mettre en contact la couche d'adhésif avec elle-même.

Selon une troisième variante, non couverte par l'invention telle que revendiquée, la méthode de mise en forme peut comporter la découpe de la feuille en plaquettes, et l'empilement des plaquettes les unes sur les autres selon une direction d'empilement. De préférence, la direction d'empilement est perpendiculaire aux plans dans lesquels les plaquettes s'étendent respectivement. De préférence, selon cette autre variante, la feuille est telle que le revêtement recouvre moins de 90 % de la face du support. L'étape d'empilement est aisée de mise en oeuvre, puisque la structure composite peut être fabriquée à partir d'un unique type de plaquette qui comporte chacune sous forme d'un bloc monolithique un support et un revêtement.

La feuille peut comporter une couche d'adhésif portée par une face du support et les plaquettes obtenues par découpe de la feuille peuvent être empilées de sorte que la couche d'adhésif maintienne en contact deux plaquettes consécutives de l'empilement.

**Brève description des figures**

L'invention pourra être mieux comprise à la lecture de la description détaillée qui va suivre, d'exemples de mise en oeuvre non limitatifs de celle-ci, et à l'examen du dessin annexé dans lequel :

[Fig 1] représente en coupe un exemple de feuille contenue dans la structure composite selon l'invention,
[Fig 2] représente en coupe un autre exemple de feuille contenue dans la structure composite selon l'invention,
[Fig 3] représente en coupe encore un autre exemple de feuille contenue dans la structure composite selon l'invention,
[Fig 4] représente une vue de dessus de l'exemple illustré sur la figure 3,
[Fig 5] a) à f) représentent d'autres exemples de feuille,
[Fig 6] a) à c) représente d'autres exemplesh de feuille,
[Fig 7] est une vue de dessus d'une feuille illustrant un exemple d'agencement particulier du revêtement sur le support,
[Fig 8] illustre un exemple de mise en oeuvre du procédé de fabrication d'une feuille contenue dans la structure composite selon l'invention,
[Fig 9] représente, selon une vue en perspective une structure composite obtenue par enroulement de la feuille illustrée sur les figures 3 et 4,
[Fig 10] représente, selon une vue axiale respectivement, une structure composite obtenue par enroulement de la feuille illustrée sur les figures 3 et 4,
[Fig 11] représente, selon une vue en perspective, une structure composite obtenue par enroulement de la feuille illustrée sur la figure 7,

[Fig 12] représente, selon une vue en perspective, une structure composite obtenue par enroulement de la feuille illustrée sur la figure 5,

[Fig 13] illustre un exemple de mise en oeuvre de la méthode de mise en forme selon l'invention,

[Fig 14] représente un exemple de structure composite, et

[Fig 15] représente un exemple de structure composite.

## Description détaillée

Par souci de clarté, les proportions relatives des éléments constitutifs de la feuille et de la structure composite n'ont pas été nécessairement respectées dans les figures.

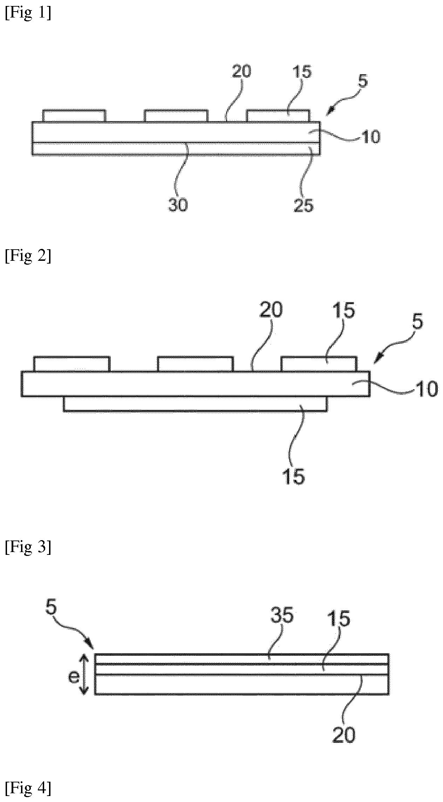

La feuille 5 illustrée sur la figure 1 comporte un support 10 et un revêtement 15. Le revêtement est au contact d'une face 20 du support.

Le support est par exemple en Kapton® commercialisé par la société Dupont ou en PET. Sur la figure 1, le revêtement recouvre partiellement la face 20. En variante, comme cela sera observé par la suite, le revêtement peut recouvrir intégralement la face 20.

La feuille illustrée comporte une couche d'adhésif 25, disposée en contact de la face 30 du support opposée à la face 20 sur laquelle le revêtement est disposé. Une telle couche d'adhésif est toutefois optionnelle.

Dans l'exemple de la figure 2, le revêtement est disposé au contact de chacune des faces 20,30 opposées du support.

Sur la figure 3, le revêtement recouvre intégralement la face 20 du support de laquelle il est en contact. Par ailleurs, la feuille comporte une couche métallique 35, qui recouvre partiellement le revêtement et s'étend sur toute la longueur de la feuille. La feuille présente une forme de bande parallélépipédique de longueur L, de largeur 1 et d'épaisseur e. La couche métallique 35, comme cela apparaît sur la figure 4, est de largeur $l_c$ plus faible que la largeur 1 de la feuille.

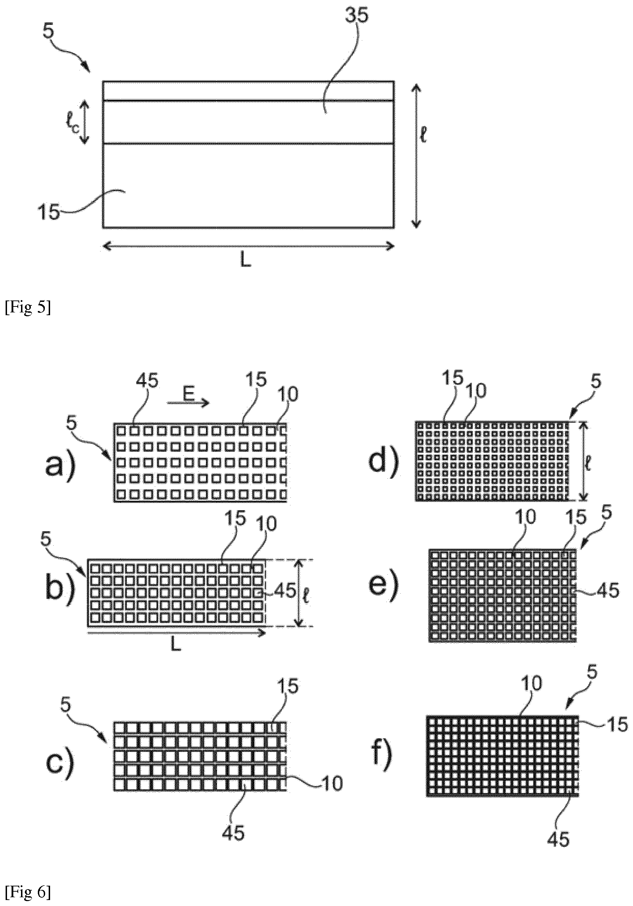

Les figures 5a à 5f illustrent d'autres exemples de feuilles selon l'invention vus selon une direction normale à une face de la feuille. Le support 10 de chacune des feuilles des figures 5a à 5f est recouvert partiellement par le revêtement 15. Le revêtement est défini par la répétition régulière selon la longueur et la largeur de la feuille d'un motif élémentaire 45 carré. Le motif élémentaire peut être rectangulaire, ou de forme losange ou circulaire.

Les feuilles des figures 5a et 5d présentent toutes deux un même rapport de l'aire couverte par le revêtement sur l'aire de la face du support sur laquelle le revêtement est disposé. En l'espèce, le rapport est égal à 0,25. Elles diffèrent en ce qu'elles comportent un nombre différent de motifs élémentaires selon la largeur de la feuille (cinq et dix pour les exemples des figures 6a et 6d respectivement).

Pour un même nombre de motifs élémentaires selon la largeur de la feuille, les exemples des figures 5b-c et 5e-f respectivement illustrent une variation du rapport de l'aire occupée par le revêtement sur l'aire de la face du support sur laquelle le revêtement est disposé, en l'espèce égaux à 0,5 et 0,75.

Selon un autre exemple illustré sur les figures 6a à 6c, les motifs élémentaires 45 sont disposés en quinconce les uns par rapport aux autres selon la longueur de la feuille. Pour chacune des feuilles illustrées, le nombre de motifs élémentaires selon la largeur de la feuille est identique et égal à 5, et le rapport de l'aire couverte par les motifs élémentaires sur l'aire de la face sur laquelle ils sont disposés est de 0,25, 0,50 et 0,75 pour les exemples des figures 6a à 6c respectivement.

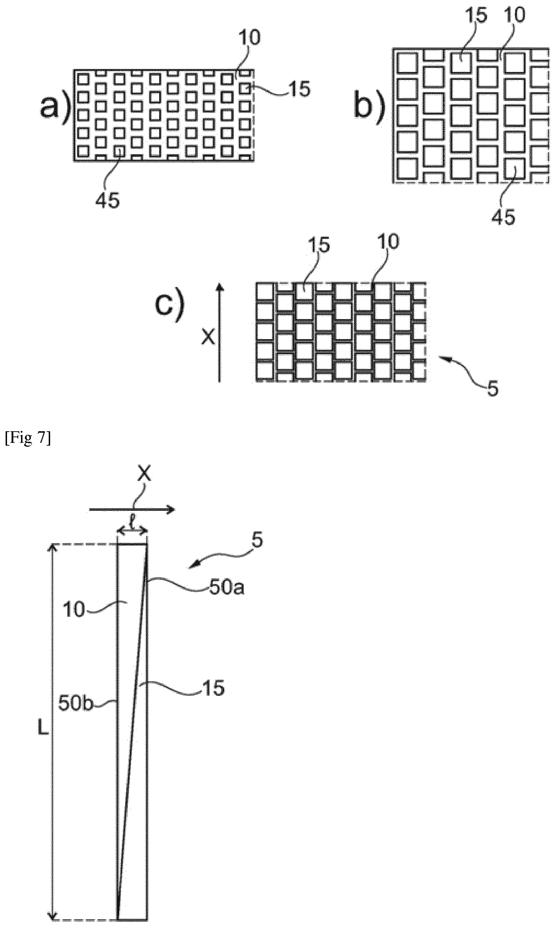

La figure 7 illustre un autre exemple de mise en oeuvre de l'invention. Le revêtement 15 s'étend progressivement d'un bord long 50a au bord long opposé 50b au fur et à mesure que l'on se déplace selon la longueur L de la feuille. L'aire revêtue par le revêtement évolue de manière linéaire entre les deux bords longs de la feuille.

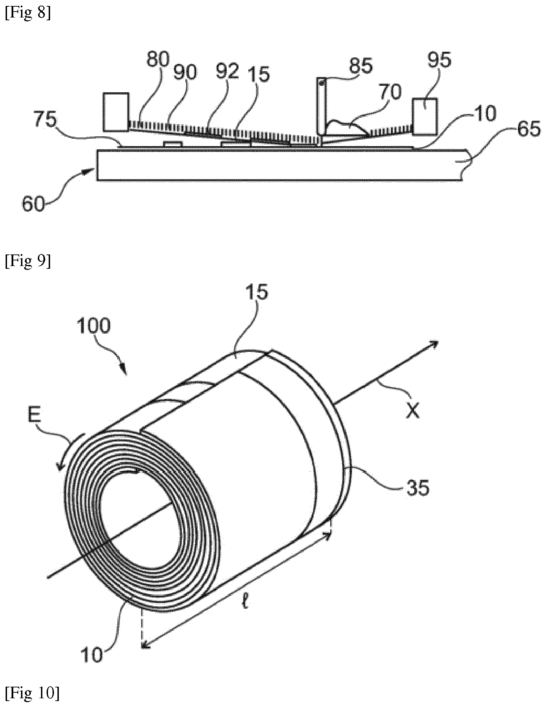

Pour fabriquer les feuilles des exemples illustrées sur les figures 1 à 7, on peut procéder comme illustré sur la figure 8 et comme détaillé ci-dessous.

On alimente un dispositif 60 d'impression par sérigraphie au moyen du support 10 flexible en un matériau de support aux propriétés diélectriques tel que décrit précédemment, par exemple en Kapton®. Le support 10 est disposé sur une table d'impression 65.

Pour effectuer une impression par sérigraphie, on peut utiliser l'encre X-nano magnetic commercialisée par la société DNC Materials, ou l'encre Nanum Ink commercialisée par la société Nanum, ou l'une des encres H400, H270, P2189 et WL330 commercialisées par la société Mulann.

On dépose l'encre 70 comportant le matériau de revêtement, par exemple un matériau magnéto-diélectrique, sur une face 75 du support 20. Dans la variante où l'on ne vise qu'à recouvrir partiellement la face du support, on dépose l'encre à travers un masque 80 et l'on applique une racle 85 en polyéthylène pour racler l'encre en surface du masque de manière à assurer une épaisseur de dépôt homogène.

Le masque est disposé sur un écran 90 formé d'une toile 92 tendue sur un cadre 95, par exemple en acier. La toile est formée de fils métalliques ou en polyester. Les fils définissent des mailles au travers desquelles l'encre peut s'écouler. L'encre est alors déposée seulement en des zones exemptes de superposition avec le masque.

L'encre est ensuite séchée, par évaporation du solvant qu'elle contient. Le séchage peut être opéré à température ambiante, ou au cours d'un recuit opéré à une température comprise entre 100 °C et 135°C, par exemple pendant une durée de 30 minutes. Le recuit peut être mis en oeuvre en irradiant l'encre au moyen d'un laser. Il peut être photonique, c'est-à-dire qu'il est mis en oeuvre au moyen d'une source lumineuse, par exemple une lampe UV flash. Avantageusement, le recuit photonique chauffe le solvant jusqu'à évaporation et fritte les particules de l'encre entre elles sans endommager le support. Le recuit photonique peut être effectué au moyen de la lampe PulseForge 3200 commercialisée par la société NovaCentrix.

On obtient ainsi une feuille plate formée du support sur lequel est déposé le revêtement 15.

Optionnellement, la feuille est ensuite être coupée de sorte à présenter une largeur et une longueur déterminée.

La feuille peut être mise en forme pour former tout ou partie d'une structure composite.

Les figures 9 et 10 illustrent un exemple de structure composite 100 comportant une feuille enroulée 100 formée par l'enroulement sur elle-même, en spirale, autour d'un axe d'enroulement X, de la feuille représentée sur les figures 3 et 4.

La feuille enroulée présente une forme générale tubulaire et creuse d'axe X.

Par exemple, elle présente :

- une largeur 1, mesurée le long de l'axe d'enroulement, comprise entre 1 mm et 1 m, par exemple égale à 10 mm,
- un diamètre extérieur De, mesuré selon une direction radiale, compris entre 2 mm et 40 mm, par exemple égal à 5 mm, et
- un diamètre intérieur Di, mesuré selon une direction radiale, compris entre 1 mm et 40 mm, par exemple égal à 4,5 mm.

La feuille enroulée est définie par l'enroulement de la feuille selon un trajet d'enroulement caractérisée par la flèche E, autour de l'axe d'enroulement X. Comme cela peut être observé sur la figure 9, le trajet d'enroulement E selon laquelle s'enroule la feuille définit une spirale d'axe X.

Le revêtement 15 est pris en sandwich entre deux enroulements consécutifs 110, 120 du support, quels que soient les enroulements considérés. Il est au contact de chacune des faces 125,130 en regard des deux enroulements consécutifs.

La feuille enroulée présente ainsi des propriétés magnéto-diélectriques ou diélectriques homogènes et anisotropes, bien que chaque enroulement définisse un ensemble aux propriétés magnéto-diélectriques ou diélectriques hétérogènes.

Notamment, la feuille enroulée peut présenter un tenseur de permittivité $\varepsilon$ et/ou un tenseur de perméabilité $\mu$, exprimé dans un repère cylindrique centré sur l'axe d'enroulement, égaux respectivement à :

[Math 1]

$$\varepsilon = \begin{pmatrix} \varepsilon_0 \varepsilon_1 & & \\ & \varepsilon_0 \varepsilon_2 & \\ & & \varepsilon_0 \varepsilon_3 \end{pmatrix}$$

et

[Math 2]

$$\mu = \begin{pmatrix} \mu_0 \mu_1 & & \\ & \mu_0 \mu_2 & \\ & & \mu_0 \mu_3 \end{pmatrix}$$

Avec $\varepsilon_0$ et $\mu_0$ étant la perméabilité et la permittivité du vide et $\varepsilon_i$ et $\mu_i$ avec i=1 à 3 étant les composantes suivant les directions axiale, radiale et orthoradiale de la perméabilité et de la permittivité de la feuille enroulée.

Par ailleurs, la couche métallique 35 est elle aussi enroulée en spirale autour de l'axe d'enroulement. Dans une variante préférée où la structure composite forme tout ou partie d'une antenne électromagnétique, les courants qui sont induits dans la couche métallique transforment une onde guidée en onde propagée.

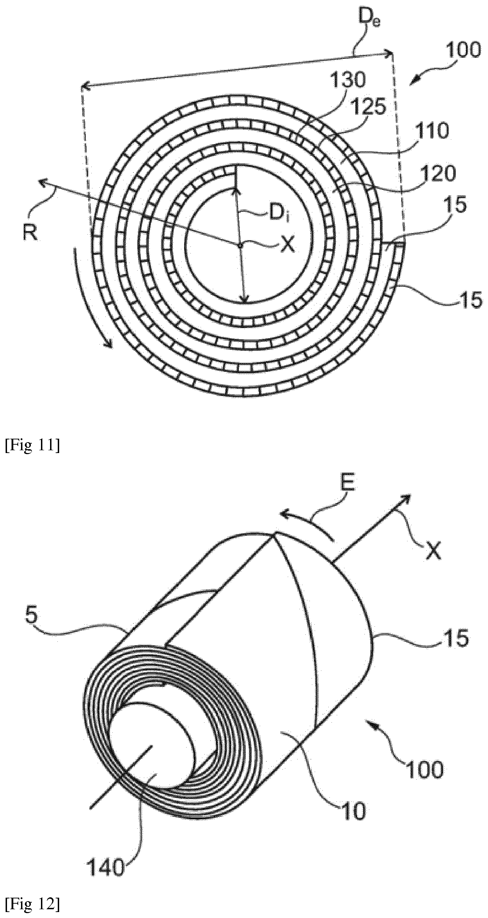

La structure composite illustrée sur la figure 11 comporte la feuille illustrée sur la figure 7 enroulée en spirale autour de l'axe d'enroulement X. Par ailleurs, la feuille est enroulée autour d'un mandrin 70, cylindrique de révolution, duquel elle est en contact.

Du fait de l'augmentation de l'aire de la surface du support recouverte par le revêtement lorsqu'on parcourt la feuille enroulée autour du trajet d'enroulement E, la structure composite illustrée sur la figure 10 présente un comportement magnéto-diélectrique ou diélectrique anisotrope et hétérogène, dépendant notamment de la distance radiale à l'axe d'enroulement ainsi que de la position selon l'axe d'enroulement.

La structure composite illustrée sur la figure 12 est obtenue par enroulement d'une feuille telle qu'illustrée sur la figure 6. La feuille de la figure 6 ainsi enroulée définit ainsi un matériau composite présentant un rapport local de la permittivité relative sur la perméabilité relative évoluant de manière périodique à la fois angulairement autour et le long de l'axe d'enroulement X respectivement.

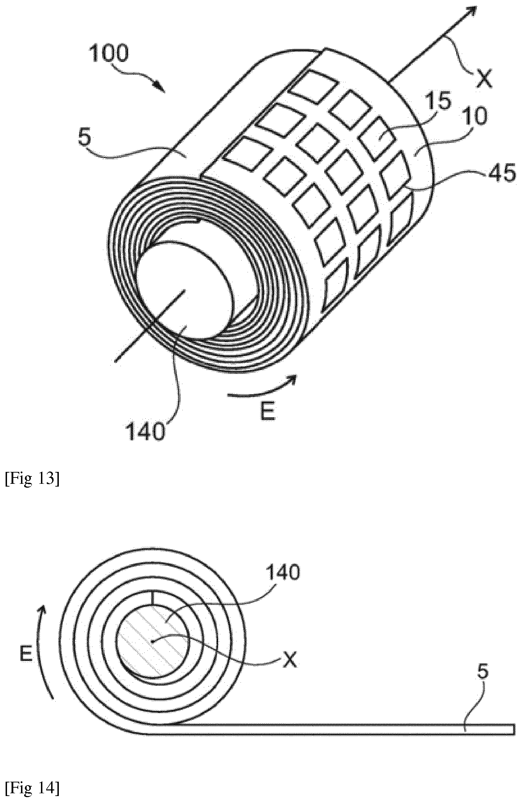

La figure 13 illustre un exemple de mise en forme d'une feuille contenue dans la structure composite selon l'invention pour produire une feuille enroulée telle que décrite ci-dessus.

Une feuille contenue dans la structure composite selon l'invention est mise en contact d'un mandrin 140 d'axe X et cylindrique de révolution, relié par exemple à un moteur. Le mandrin est mis en rotation de sorte à enrouler la feuille sur elle-même pour former la feuille enroulée d'une structure composite selon l'invention.

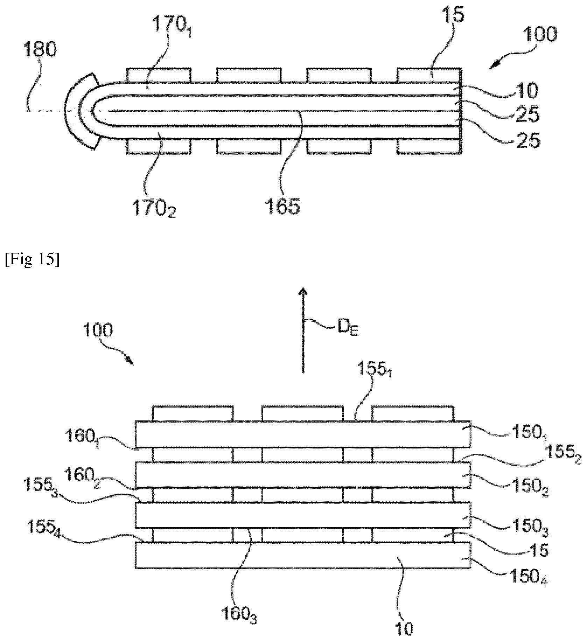

La méthode de mise en forme peut comporter la découpe d'une feuille contenue dans la structure composite selon l'invention, par exemple selon la largeur de la feuille, de manière à former une pluralité de plaquettes $150_{1-4}$. Les plaquettes sont ensuite empilées les unes sur les autres, comme illustré sur la figure 15, selon une direction d'empilement $D_E$ normale à une de leurs faces $155_{1-4}$ respectives de manière à former la structure composite 100. Afin d'assurer la cohésion entre les plaquettes au sein de la structure composite, la feuille peut comporter une couche d'adhésif disposée sur la face $155_{2-4}$ recouverte par le revêtement ou sur la face $160_{1-3}$ qui lui est opposée. En variante, préalablement à l'assemblage des plaquettes entre elles, un adhésif peut être enduit entre deux plaquettes consécutives de l'empilement.

La méthode de mise en forme peut comporter le pliage de la feuille sur elle-même, par exemple de manière à amener une face 165 de la feuille en contact avec elle-même, comme cela est illustré sur la figure 14. Dans cet exemple, la feuille comporte une couche d'adhésif 25 disposée sur une face du support 10 opposée à celle recouverte par le revêtement 15. Au cours de l'étape de pliage, la couche d'adhésif 25 est amenée en contact avec elle-même, de manière à lier entre elles les parties $170_{1-2}$ de la feuille disposées de part et d'autre de la ligne de pliage 180.

Comme cela apparaît clairement de la présente description, l'invention permet de fabriquer, de manière simple et en quantités industrielles, une structure composite, qui présente des propriétés magnéto-diélectriques anisotropes et/ou hétérogènes.

Bien évidemment, l'invention n'est pas limitée aux modes de réalisation et de mise en oeuvre présentés ci-dessus à titre illustratif.

## Revendications

1. Structure composite (100) comportant une feuille (5) comportant un support (10) flexible et un revêtement (15) recouvrant au moins partiellement au moins une face du support, le support étant en un matériau de support présentant des propriétés diélectriques, le revêtement étant en un matériau de revêtement différent du matériau de support et présentant des propriétés magnéto-diélectriques,
la feuille étant enroulée sur elle-même autour d'un axe d'enroulement (X), ou repliée sur elle-même.

2. Structure composite selon la revendication 1, le matériau de support étant un polymère thermoplastique ou thermodurcissable, par exemple choisi parmi un polyimide, le polyvinyl siloxane, le polyéthylène, le polypropylène, le polystyrène, l'acrylonitrile butadiène styrène et leurs mélanges, ou étant un composite à base de fibres de verre.

3. Structure composite selon l'une quelconque des revendications précédentes, dans lequel le revêtement recouvre intégralement au moins une face du support.

4. Structure composite selon l'une quelconque des revendications 1 et 2, dans lequel le revêtement recouvre partiellement une face du support, et est de préférence formé de motifs élémentaires (45) espacés les uns des autres.

5. Structure composite selon la revendication précédente, les motifs élémentaires définissant un agencement régulier, de préférence périodique, selon au moins une, de préférence deux directions, notamment selon la largeur et/ou la longueur de la feuille.

6. Structure composite selon l'une quelconque des revendications 4 et 5, le revêtement recouvrant moins de 90 % de l'aire d'une face du support.

7. Structure composite selon l'une quelconque des revendications précédentes, comportant une couche métallique (35), recouvrant notamment au moins partiellement, et de préférence partiellement seulement, une face du support.

**8.** Structure composite selon l'une quelconque des revendications précédentes, la feuille étant enroulée le long d'un trajet d'enroulement (E) définissant une spirale perpendiculaire à l'axe d'enroulement (X).

**9.** Structure composite selon la revendication précédente, présentant une forme générale tubulaire, et de préférence creuse, s'étendant selon l'axe d'enroulement.

**10.** Dispositif pour émettre et/ou capter une onde électromagnétique, le dispositif comportant une antenne électromagnétique comportant une structure composite selon la revendication précédente.

**11.** Procédé comportant

- la fabrication d'une feuille telle que définie dans l'une quelconque des revendications 1 à 9, la fabrication comportant le dépôt d'une encre (70) comportant le matériau de revêtement sur au moins une face du support, pour former le revêtement,
- la mise en forme de la feuille comportant l'enroulement de la feuille sur elle-même autour d'un axe d'enroulement (X) ou le pliage de la feuille sur elle-même.

**12.** Procédé selon la revendication précédente, dans lequel la fabrication de la feuille comporte le dépôt de l'encre au moyen d'une technique choisie parmi la sérigraphie, le dépôt à la tournette, le dépôt au racloir, le dépôt par spray ultrasonique, l'enduction par filière à fente, l'impression jet d'encre, la flexographie et l'héliogravure, de préférence on dépose l'encre par sérigraphie.

**Patentansprüche**

**1.** Verbundstruktur (100), welche eine Folie (5) umfasst, die einen flexiblen Träger (10) und eine Beschichtung (15), die wenigstens eine Seite des Trägers wenigstens teilweise bedeckt, umfasst, wobei der Träger aus einem Trägermaterial besteht, das dielektrische Eigenschaften aufweist, wobei die Beschichtung aus einem Beschichtungsmaterial besteht, das von dem Trägermaterial verschieden ist und magneto-dielektrische Eigenschaften aufweist, wobei die Folie um eine Wickelachse (X) auf sich selbst gewickelt ist oder auf sich selbst gefaltet ist.

**2.** Verbundstruktur nach Anspruch 1, wobei das Trägermaterial ein thermoplastisches oder duroplastisches Polymer ist, das zum Beispiel aus einem Polyimid, Polyvinylsiloxan, Polyethylen, Polypropylen, Polystyrol, Acrylnitril-Butadien-Styrol und deren Mischungen gewählt ist, oder ein Verbundmaterial auf Glasfaserbasis ist.

**3.** Verbundstruktur nach einem der vorhergehenden Ansprüche, wobei die Beschichtung wenigstens eine Seite des Trägers vollständig bedeckt.

**4.** Verbundstruktur nach einem der Ansprüche 1 und 2, wobei die Beschichtung eine Seite des Trägers teilweise bedeckt und vorzugsweise von elementaren Mustern (45) gebildet wird, die voneinander beabstandet sind.

**5.** Verbundstruktur nach dem vorhergehenden Anspruch, wobei die elementaren Muster eine regelmäßige, vorzugsweise periodische Anordnung in mindestens einer, vorzugsweise in zwei Richtungen definieren, insbesondere entlang der Breite und/oder der Länge der Folie.

**6.** Verbundstruktur nach einem der Ansprüche 4 und 5, wobei die Beschichtung weniger als 90 % der Fläche einer Seite des Trägers bedeckt.

**7.** Verbundstruktur nach einem der vorhergehenden Ansprüche, welche eine metallische Schicht (35) umfasst, die eine Seite des Trägers insbesondere wenigstens teilweise und vorzugsweise nur teilweise bedeckt.

**8.** Verbundstruktur nach einem der vorhergehenden Ansprüche, wobei die Folie entlang eines Wickelweges (E) gewickelt ist, der eine zur Wickelachse (X) senkrechte Spirale definiert.

**9.** Verbundstruktur nach dem vorhergehenden Anspruch, die eine rohrförmige und vorzugsweise hohle allgemeine Form aufweist, die sich entlang der Wickelachse erstreckt.

**10.** Vorrichtung zum Senden und/oder Empfangen einer elektromagnetischen Welle, wobei die Vorrichtung eine elektromagnetische Antenne umfasst, die eine Verbundstruktur nach dem vorhergehenden Anspruch aufweist.

11. Verfahren, welches umfasst:

   - die Herstellung einer Folie, wie in einem der Ansprüche 1 bis 9 definiert, wobei die Herstellung die Aufbringung einer Farbe (70), die das Beschichtungsmaterial umfasst, auf wenigstens eine Seite des Trägers umfasst, um die Beschichtung zu bilden,
   - die Formgebung der Folie, welche das Wickeln der Folie um eine Wickelachse (X) auf sich selbst oder das Falten der Folie auf sich selbst umfasst.

12. Verfahren nach dem vorhergehenden Anspruch, wobei die Herstellung der Folie die Aufbringung der Farbe mittels einer Technik umfasst, die aus dem Siebdruck, der Drehbeschichtung, der Aufbringung mittels Rakel, der Aufbringung durch Ultraschallsprühen, der Schlitzdüsen-Beschichtung, dem Tintenstrahldruck, dem Flexodruck und dem Tiefdruck ausgewählt ist, wobei die Farbe vorzugsweise durch Siebdruck aufgebracht wird.

## Claims

1. Composite structure (100) comprising a sheet (5) comprising a flexible support (10) and a coating (15) at least partially covering at least one face of the support, the support being made of a support material having dielectric properties, the coating being made of a coating material different from the support material and having magneto dielectric properties,
   the sheet being wound on itself about a winding axis (X), or folded back on itself.

2. Composite structure according to Claim 1, the support material being a thermoplastic or thermosetting polymer, for example chosen from among a polyimide, polyvinyl siloxane, polyethylene, polypropylene, polystyrene, acrylonitrile butadiene styrene and the mixtures thereof, or being a composite based on glass fibres.

3. Composite structure according to either one of the preceding claims, wherein the coating fully covers at least one face of the support.

4. Composite structure according to either one of Claims 1 and 2, wherein the coating partially covers a face of the support, and is preferably formed by elementary patterns (45) spaced apart from one another.

5. Composite structure according to the preceding claim, the elementary patterns defining a regular arrangement, preferably periodic, in at least one, preferably two, directions, notably widthwise and/or lengthwise of the sheet.

6. Composite structure according to either one of Claims 4 and 5, the coating covering less than 90% of the area of a face of the support.

7. Composite structure according to any one of the preceding claims, comprising a metallic layer (35), covering, notably at least partially, and preferably partially only, a face of the support.

8. Composite structure according to any one of the preceding claims, the sheet being wound along a winding path (E) defining a spiral at right angles to the winding axis (X).

9. Composite structure according to the preceding claim, having a tubular, and preferably hollow, general form extending along the winding axis.

10. Device for emitting and/or picking up an electromagnetic wave, the device comprising an electromagnetic antenna, comprising a composite structure according to the preceding claim.

11. Method comprising

   - the production of a sheet as defined in any one of Claims 1 to 9, the production comprising the deposition of an ink (70) comprising the coating material on at least one face of the support, to form the coating,
   - the shaping of the sheet comprising the winding of the sheet on itself about a winding axis (X) or the folding of the sheet back on itself.

12. Method according to the preceding claim, wherein the production of the sheet comprises the deposition of the ink by means of a technique chosen from among screen printing, spin coating, squeegee coating, ultrasonic spray deposition, slot die coating, inkjet printing, flexography and photogravure, preferably the ink is deposited by screen printing.

[Fig 1]

[Fig 2]

[Fig 3]

[Fig 4]

[Fig 5]

[Fig 6]

a)

10
15
45

b)

15 10
45

c)

X

15 10
5

[Fig 7]

X

5
50a
10
15
50b
L

[Fig 8]

[Fig 9]

[Fig 10]

[Fig 11]

[Fig 12]

[Fig 13]

[Fig 14]

[Fig 15]

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2011036418 A1
- US 2011135884 A1
- WO 2013154713 A1

**Littérature non-brevet citée dans la description**

- **H. MOSALLAEI ; K. SARABANDI.** Engineered meta substrate for antenna miniutarization. *Ann. Arbor,* 2004, vol. 1001, 48109-2122
- **FARHAN A. GHAFFAR et al.** A ferrite nano-particles based fully printed process for tunable microwave components. *IEEE MTT-S International Microwave Symposium,* 2016